# EUROPÄISCHE PATENTSCHRIFT

(11) **EP 2 225 785 B1**
(45) Veröffentlichungstag und Bekanntmachung des Hinweises auf die Patenterteilung: **15.03.2017**
(21) Anmeldenummer: 08854876.3
(22) Anmeldetag: 21.11.2008
(51) Int. Cl.: H01L 33/62, H01L 33/48, H01L 25/075

(54) **CHIPANORDNUNG, ANSCHLUSSANORDNUNG, LED SOWIE VERFAHREN ZUR HERSTELLUNG EINER CHIPANORDNUNG**
CHIP ASSEMBLY, CONNECTING ASSEMBLY, LED AND METHOD FOR PRODUCING A CHIP ASSEMBLY
ENSEMBLE PUCE, ENSEMBLE DE CONNEXION, LED ET PROCÉDÉ DE FABRICATION D'UN ENSEMBLE PUCE

(30) Priorität: 28.11.2007 DE 102007057242; 30.04.2008 DE 102008021618
(43) Veröffentlichungstag der Anmeldung: 08.09.2010
(73) Patentinhaber: Osram Opto Semiconductors Gmbh, 93055 Regensburg (DE)
(72) Erfinder: BRUNNER, Herbert, 93161 Sinzing (DE); KÖHLER, Steffen, 10250 Penang (MY); SCHWARZ, Raimund, 93053 Regensburg (DE); GRÖTSCH, Stefan, 93077 Lengfeld - Bad Abbach (DE)
(74) Vertreter: Epping - Hermann - Fischer
(86) Internationale Anmeldenummer: PCT/DE2008/001931
(87) Internationale Veröffentlichungsnummer: WO 2009/067996

(56) Entgegenhaltungen:
- WO-A-02/43134
- DE-A1- 10 117 889
- DE-A1-102004 009 284
- JP-A- 58 066 374
- US-A1- 2005 116 235
- US-A1- 2006 030 063
- US-A1- 2007 007 540
- US-A1- 2007 253 209

## Beschreibung

Die Erfindung bezieht sich auf eine Chipanordnung für ein optoelektronisches Bauelement mit zumindest einem, eine elektromagnetische Strahlung aussendenden Halbleiterchip und auf ein Verfahren zur Herstellung einer solchen Chipanordnung.

Heutzutage werden bevorzugt so genannte Halbleiterbauelemente als Lichtquelle verwendet. Eine Lumineszenzdiode (LED), auch als Leuchtdiode bezeichnet, ist dabei eine sehr kostengünstige und effektive Lichtquelle. Ausgangspunkt für die Herstellung von LED-Chips ist ein einkristallines Grundmaterial. Beispielhaft erwähnt seien hier Silizium und Germanium. Silizium weist IV-wertige Siliziumatome auf, wobei IV-wertige Elemente vier Außenelektronen für Atombindungen besitzen.

Durch Dotierung dieses Grundmaterials werden Donator- bzw. Akzeptoratome in das Kristallgitter des Grundmaterials eingefügt. Dadurch werden gezielt Eigenschaften, beispielsweise die Leitfähigkeit, dieses Grundmaterials verändert. Bei beispielsweise der n-Dotierung, wobei n für die frei bewegliche negative Ladung, die eingebracht wird, steht, werden V-wertige Elemente, so genannte Donatoren, in das Siliziumgitter eingebracht und ersetzten dafür IV-wertige Siliziumatome. Ein V-wertiges Element hat fünf Außenelektronen für Atombindungen zur Verfügung, sodass bei der Einbindung in den Siliziumkristall ein Außenelektron des Donators freibeweglich zur Verfügung steht. Dieses Elektron kann beim Anlegen einer Spannung Arbeit verrichten. An der Stelle des Donatoratoms entsteht eine ortsfeste positive Bindung, der eine negative Ladung des frei beweglichen Elektrons gegenüber steht. Für die n-Dotierung eines Grundmaterials wird beispielsweise Phosphor, Arsen oder Antimon verwendet.

Im Gegensatz wird bei der p-Dotierung, wobei p für die freibewegliche positive Lücke (Loch) steht, werden III-wertige Elemente, so genannte Akzeptoren, in das Siliziumgitter eingebracht und ersetzen das IV-wertige Siliziumatom. Analog besitzen III-wertige Elemente drei Außenelektronen für Atombindungen. Beim Anlegen einer Spannung verhält sich dieses Loch wie ein frei beweglicher positiver Ladungsträger und kann analog zum negativ geladenen Elektron Arbeit verrichten. An der Stelle des Akzeptoratoms entsteht eine ortsfeste negative Ladung, der eine positive Ladung des freibeweglichen Loches gegenüber steht. Um ein Halbleiterbauelement p zu dotieren, wird beispielsweise Bor, Indium, Aluminium oder Gallium verwendet.

Ebenfalls könnte der III-IV-Halbleiter Galliumarsenid mit den IV-wertigen Elementen Kohlenstoff, Silizium oder mit Gold dotiert werden.

LED-Chips benötigen zum Emittieren von elektromagnetischer Strahlung eine so genannte pn-Struktur, das heißt, ein p-dotiertes Material wird mit einem n-dotierten Material verbunden. Durch Anlegen einer elektrischen Spannung, die höher ist als die Schwellspannung der Struktur (engl. threshold voltage), wird von dieser pn-Struktur Licht einer bestimmten Wellenlänge emittiert. Dabei sind die Wellenlänge, die Intensität des Lichtes und die Höhe der anzulegenden elektrischen Spannung von der Art der Dotierung und dem Aufbau der jeweiligen pn-Struktur abhängig.

Der Aufbau eines LED-Chips (Licht emittierende Halbleiterchips) ist nun nicht zwingend gleich. Zum einen kann die p-dotierte Schicht auf einer Oberseite eines LED-Chips angeordnet sein, zum anderen auf einer Unterseite des LED-Chips. Diese Arten von LED-Chips werden in der Fachwelt als p-up-n-down-LED-Chips bezeichnet. Es spielt hierbei keine Rolle, ob eine p-Anschlussstelle oder eine n-Anschlussstelle auf der Oberseite vorhanden ist. Die dementsprechend andere Anschlussstelle eines LED-Chips befindet sich auf der entsprechend entgegengesetzten Seite des LED-Chips. Ein Substrat zwischen den Anschlussstellen ist hierbei vorzugsweise elektrisch nicht isolierend, sprich elektrisch leitend, auszugestalten.

In einem anderen LED-Aufbau sind sowohl die n-Anschlussstelle als auch die p-Anschlussstelle auf einer Oberseite des LED-Chips angeordnet. Das Substrat ist in einem solchen Fall idealerweise elektrisch isolierend auszugestalten.

Im Folgenden wird der Ausdruck "unterschiedlich aufgebaute LED-Chips oder Halbleiterchips" gleichgesetzt mit den unterschiedlich angeordneten n- bzw. p-Anschlussstellen.

Zur Steigerung der emittierten Lichtleistung einer LED, zur Mischung von unterschiedlichen Wellenlängen und/oder zur Optimierung des ausgesendeten Lichtkegels auf unterschiedliche Anforderungen ist es üblich, mehrere Licht emittierende Halbleiterchips (LED-Chips) in einem gemeinsamen Gehäuse anzuordnen.

Um für Leistungslichtquellen vielfältige Verschaltungsvarianten zu erhalten, ist es nun beispielsweise nötig, mehrere unterschiedlich aufgebaute Halbleiterchips in einer gemeinsamen Anordnung bzw. in einem gemeinsamen Gehäuse unterzubringen. Eine solche Anordnung wird auch als Chipanordnung bezeichnet. Zum Einbringen unterschiedlich aufgebauter Halbleiterchips innerhalb einer Chipanordnung werden bislang aufwendige Verschaltungskonzepte innerhalb der Anordnung realisiert. Diese Verschaltungskonzepte verhindern zwar ein mögliches Kurzschließen der LED-Chips und ermöglichen eine individuelle Ansteuerung der einzelnen LED, sind aber nur sehr aufwändig realisierbar, wodurch die Kosten zur Herstellung sehr hoch sind. Zusätzlich ist es bei diesen Chipanordnungen schwierig, für den jeweiligen LED-Chip eine optimale Wärmeableitung herzustellen.

Die Druckschrift US 2007/0253209 A1 beschreibt ein Package mit einem Gehäusekörper und mit zwei strahlungsemittierenden Halbleiterchips in einer Öffnung darin. Der Gehäusekörper weist einen Leiter sowie einen Träger auf einer Wärmesenke aus Kupfer auf, wobei die beiden Träger durch den Gehäusekörper voneinander elektrisch isoliert sind. Die Chips sind jeweils über den Leiter und den Träger elektrisch kontaktiert.

Aufgabe der hier vorliegenden Erfindung ist es, mehrere unterschiedlich aufgebaute Halbleiterchips innerhalb einer Chipanordnung anzuordnen, ohne kostenintensive Verschaltungskonzepte entwerfen zu müssen und darüber hinaus für jeden einzelnen Halbleiterchip eine optimale Wärmeanbindung zu realisieren.

Diese Aufgabe wird durch die in den nebengeordneten Patentansprüchen angegebenen Maßnahmen gelöst. Weitere vorteilhafte Ausgestaltungen werden in den Unteransprüchen angegeben.

Die Aufgabe wird dadurch gelöst, dass eine Chipanordnung für ein optoelektronisches Bauelement mit zumindest einem, eine elektromagnetische Strahlung emittierenden Halbleiterchip und einer Anschlussanordnung, wobei die Anschlussanordnung voneinander elektrisch isolierte Ebenen aufweist und in zumindest zwei Ebenen zumindest zwei elektrisch isolierte Leiter angeordnet sind, in zumindest einer Ebene eine Kavität aufweist, der Halbleiterchip innerhalb der Kavität angeordnet ist und die Chipanordnung zumindest zwei Anschlussstellen aufweist, jede der Anschlussstellen mit jeweils einem der Leiter elektrisch leitend verbunden ist und zumindest eine der Ebenen eine Wärmeableitebene ist.

Zusätzlich ist in der Chipanordnung ein zweiter Halbleiterchip, der nicht zwingend wie der erste Halbleiterchip aufgebaut ist, innerhalb der Kavität eingebracht. Der zweite Halbleiterchip weist ebenfalls zumindest zwei Anschlussstellen auf und jede der Anschlussstellen ist mit jeweils einem Leiter elektrisch leitend verbunden. Hierzu weist eine der zwei Ebenen zumindest einen dritten, elektrisch von den anderen Leitern isolierten Leiter auf. Werden nun zwei unterschiedliche aufgebaute LED-Chips innerhalb der Chipanordnung angeordnet, so ist es durch diese Chipanordnung möglich, beide LED-Chips in Reihe zu verschalten. Hierzu ist in vorteilhafter Weise die zweite Ebene als elektrisch leitfähig auszubilden. In einem anderen Schaltungskonzept wird zweite Anschlussstelle des zumindest zweiten Halbleiterchips mit einem weiteren, elektrisch isolierten Leiter der ersten Ebene verbunden, wodurch ein separates Ansteuern der LED-Chips realisierbar ist. In dieser Verschaltung kann die Wärmeableitebene elektrisch nicht leitfähig ausgebildet sein. Somit ist einfache Weise ein Verschaltungskonzept zu realisieren und die unterschiedlich aufgebauten Halbleiterchips einzeln oder zusammen anzusteuern bzw. beliebig miteinander zu verbinden.

In einer weiteren Ausgestaltung ist die Wärmeableitschicht aufgeteilt und die Teile der Wärmeableitebene sind räumlich voneinander getrennt. Durch diese Maßnahme ist es möglich, für jeden Halbleiterchip einzeln die Wärme optimal abzuführen. Dadurch kann auch abhängig vom jeweiligen unterschiedlich aufgebauten Halbleiterchip ein verschieden großer Teil der Wärmeableitebene vorgesehen sein, um ideal den Gegebenheiten des LED-Chips angepasst zu sein.

Werden unterschiedlich aufgebaute Halbleiterchips in die Anordnung eingebracht, ist eine Reihenschaltung der einzelnen Chips ohne zusätzliche Isolation oder zusätzliches elektrisches Verbinden möglich. Werden in die Anordnung gleich aufgebaute Halbleiterchips eingebracht, so ist die zweite Ebene als gemeinsamer elektrisch isolierter Leiter ausgebildet.

In einer alternativen Ausgestaltung sind die einzelnen Halbleiterchips untereinander in Reihe und/oder parallel verbindbar. Durch die Anschlussanordnung ist es auf einfache Weise möglich, über die zumindest zwei Ebenen ein möglichst einfaches Verschaltung zu konzipieren. Dadurch lassen sich unterschiedliche Wellenlängen, beispielsweise eine RGB-Anordnung, individuell, flexibel und optimal ansteuern. Weiterhin lässt sich dadurch die Lichtintensität der Chipanordnung steigern.

In einer weiteren Ausgestaltung ist die Chipanordnung mit einem optischen Element versehen. Durch dieses optische Element ist es möglich, die ausgesendete elektromagnetische Strahlung abzulenken, zu reflektieren oder zu bündeln. Hierdurch wird eine optimale Ausleuchtung erreicht.

In einer weiteren vorteilhaften Ausgestaltung ist die Anschlussanordnung mit einer dritten Ebene, der Halteebene, ausgestattet, die als Halteebene für das optische Element ausgebildet ist. Durch das Erweitern der Anschlussanordnung mit dieser dritten Ebene ist es möglich, eine kostengünstige Anordnung zu schaffen.

Durch Umspritzen der einzelnen Ebenen mit einem Kunststoff sind die einzelnen Schichten elektrisch isoliert und darüber hinaus kostengünstig herstellbar.

In einer weiteren Ausgestaltung weist die Chipanordnung elektrische Anschlüsse auf, die in Form von Steckerkontakten, Lötpins oder Schneidklemmverbindung ausgestaltet sind, welche elektrisch leitend mit den einzelnen Leitern verbunden sind. Hierdurch kann beispielsweise mittels ISO- oder IEC-genormten Steckkontakten eine elektrische Ansteuerung zur Chipanordnung hergestellt werden.

In einer weiteren vorteilhaften Ausgestaltung sind die Halbleiterchips mit einem isolierenden Platinsubstrat realisiert. Vorzugsweise sind beide Anschlussstellen des LED-Chips auf einer ersten Oberseite des LED-Chips angeordnet. Zusätzlich ist es möglich, die Wärmeableitebene elektrisch isolierend, sprich nicht elektrisch leitfähig, auszugestalten.

Darüber hinaus ist die Wärmeableitebene in einer weiteren vorteilhaften Ausgestaltung eine Wärmesenke und direkt mit einem elektrisch leitenden Kühlkörper wärmeableitbar verbunden. Dabei ist die Wärmeableitebene vorzugsweise elektrisch leitfähig auszugestalten. Somit wird zum einen ein genügender Wärmeabtransport erreicht. Die im Inneren der Chipanordnung durch die Halbleiterchips entstehende Wärme wird so optimal abgeführt. Zum anderen ist eine elektrisch leitfähige Verbindung einfach realisiert.

Ebenfalls im Erfindungsgedanken enthalten ist eine Anschlussanordnung für ein optoelektronisches Bauelement sowie eine LED mit einem Gehäuse, einer Abdeckung, elektrischen Anschlüssen und einer Multichip-Anordnung.

Die Anschlussanordnung für ein optoelektronisches Bauelement ist vorzugsweise aus mehreren voneinander elektrisch isolierten Ebenen aufgebaut, wobei in zumindest zwei Ebenen zumindest zwei elektrisch isolierte Leiter angeordnet sind, die einzelnen Ebenen mittels Kunststoff umspritzt sind, eine erste Ebene der Anschlussanordnung eine Anschlussebene ist, und eine zweite Ebene der Anschlussanordnung eine Wärmeableitebene ist.

Bevorzugt weist die Anschlussanordnung eine dritte Ebene auf, die als Halteebene für ein optisches Element ausgebildet ist.

Die LED mit einem Gehäuse weist vorzugsweise eine Abdeckung, elektrische Anschlüsse und eine Anschlussanordnung auf, wobei die elektrischen Anschlüsse mit den Leitern elektrisch leitend verbunden sind und zumindest ein zweiter Halbleiterchip in der Kavität eingebracht ist.

Bevorzugt ist die Wärmeableitebene geteilt und die Teile sind derart räumlich voneinander getrennt, dass für jeden Halbleiterchip einzeln optimal Wärme an das Gehäuse ableitbar ist.

Besonders bevorzugt sind die elektrischen Anschlüsse Steckerkontakte, Lötpins und/oder Schneidklemmverbindungen.

Vorzugsweise weisen die Halbleiterchips ein elektrisch isolierendes Platinsubstrat auf.

Bevorzugt ist das Gehäuse direkt mit einem elektrisch leitfähigen Kühlkörper wärmekoppelbar.

Zusätzlich weist ein Verfahren zur Herstellung einer Chipanordnung die folgenden Verfahrensschritte auf:
- Fertigen eines ersten Leadframes und Ausbilden dieses ersten Leadframes als Anschluss-Leadframe,
- Fertigen eines zweiten Leadframes und Ausbilden dieses zweiten Leadframes als ein Wärmeableit-Leadframe,
- Umspritzen der Leadframes mittels Spritzgussverfahren,
- Ausbilden einer Kavität innerhalb zumindest eines Leadframes,
- Platzieren von Halbleiterchips innerhalb der Kavität,
- Elektrisches Verbinden der Halbleiterchips mit den Leadframes und
- Vergießen der Halbleiterchips innerhalb der Kavität.

Als Leadframe, auch als Leiterbahnrahmen bezeichnet, wird hier ein eingebrachtes Zwischenmaterial verstanden, welches in die jeweilige Ebene eingefügt wird. Dieses Zwischenmaterial ist bevorzugt ein gestanztes Blech oder ein anderes gestanztes elektrisch leitfähiges Material. Durch das Stanzen werden die in der jeweiligen Ebene benötigten Anpassungen vorgenommen. In der ersten Ebene betrifft dies das Ausbilden der isolierten Leiter, die während der Fertigung alle durch einen umgebenden Rahmen (frame) noch mechanisch verbunden sind. In der Wärmeableitebene ist in bevorzugter Weise eine Teilung des Materials zur besseren Wärmeabfuhr vollzogen. Auch hier sind die Teile der Wärmeableitebene während der Fertigung durch einen die Fläche umgebenden Rahmen (frame) noch mechanisch verbunden.

In einer bevorzugten Ausgestaltung wird ein dritter Rahmen, der Halte-Leadframe, ebenfalls eingefügt, wobei der Halte-Leadframe ein optisches Element oder die Abdeckung der Chipanordnung hält.

In einer bevorzugten Ausgestaltung weisen die Halbleiterchips ein nicht-isolierendes Substrat auf und werden in Reihe verschaltet.

In einer bevorzugten Ausgestaltung wird die Wärmeableitschicht direkt mit einem elektrisch leitfähigen Kühlkörper verbunden, der die von den Halbleiterchips erzeugte Wärme ableitet.

Sind die Leadframes in die Anordnung eingebracht und in einem weiteren Verfahrensschritt mittels Kunststoff umspritzt, wird zunächst eine Isolierung zwischen den einzelnen Leadframes hergestellt. Die noch alles mechanisch verbindenden Rahmen werden in einem weiteren Verfahrensschritt abgetrennt, wodurch lediglich die gestanzten Bereiche übrig bleiben und im Idealfall keine mechanische oder elektrische Verbindung zwischen den einzelnen Stanzungen vorherrscht. Die Leadframes entsprechen ab diesem Verfahrensschritt der Anschlussanordnung.

Nachfolgend wird die Erfindung anhand von Ausführungsbeispielen mit Bezugnahme auf die Zeichnungen erläutert, wobei in den Figuren gleiche oder gleich wirkende Bestandteile jeweils mit den gleichen Bezugszeichen gekennzeichnet sind. Die dargestellten Elemente sind nicht als maßstabsgerecht anzusehen, vielmehr können einzelne Elemente zum besseren Verständnis übertrieben groß beziehungsweise übertrieben vereinfacht dargestellt sein.

Es zeigen:
Figur 1 ein Beispiel einer Chipanordnung,
Figur 2 eine Weiterbildung der in Figur 1 dargestellten Chipanordnung,
Figur 3A eine Draufsicht der in Figur 2 dargestellten Chipanordnung mit einer möglichen Verschaltung der einzelnen Halbleiterchips,
Figur 3B eine Draufsicht der in Figur 2 dargestellten Chipanordnung mit einer alternativen Verschaltung,
Figur 4 eine Weiterbildung der in Figur 2 dargestellten Chipanordnung,
Figur 5 eine LED mit einer erfindungsgemäßen Chipanordnung,
Figur 6 eine Weiterbildung der in Figur 5 dargestellten LED,
Figuren 7A bis 7D dreidimensionale Ausführungsbeispiele der in den Figuren 2 bis 6 dargestellten LED beziehungsweise Chipanordnung.
Figur 8A bis 8C mögliche Aufbauten von LED-Chips.

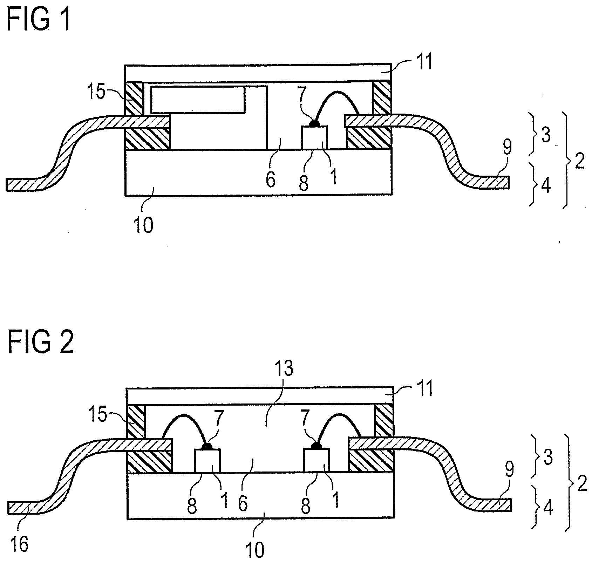

Figur 1 zeigt ein Beispiel einer Chipanordnung. Hierbei ist eine Anschlussanordnung 2 mit einer ersten Ebene 3 und einer zweiten Ebene 4 dargestellt. Innerhalb einer Kavität 6 der Anschlussanordnung 2 ist ein Halbleiterchip 1 eingebracht. Innerhalb der Kavität 6 ist weiterhin eine Vergussmasse 13 vorsehbar. Die einzelnen Ebenen 3 und 4 der Anschlussanordnung 2 sind untereinander elektrisch isoliert. Dazu sind die einzelnen Schichten 3 und 4 mit einem Kunststoffmaterial 15 umspritzt. Eine Abdeckung 11 schließt die Kavität 6 ab und schützt die Halbleiterchips vor äußeren Einflüssen. Zusätzlich weist die erste Ebene 3 einen ersten Leiter 9 auf. Der Halbleiterchip 1 ist mittels einer ersten Anschlussstelle 7 mit dem ersten Leiter 9 elektrisch leitend verbunden. Die Verbindung ist vorzugsweise mittels Bondverfahren zu realisieren. Die zweite Ebene 4 weist hier einen zweiten Leiter 10 auf. Die zweite Anschlussstelle 8 des Halbleiterchips 1 ist mit dem zweiten Leiter 10 elektrisch leitend verbunden. Die beiden Anschlussstellen 7 und 8 werden in der Technik oft als Anode und Kathode bezeichnet, wobei hier offen bleibt, welche Anschlussstelle 7 oder 8 konkret Anode bzw. Kathode ist. Eine Funktion des Halbleiterchips, sprich das Leuchten der LED, ist hierin bei jedem Schaltungskonzept anzustreben, wodurch die zweite Ebene 4 elektrisch leitfähig auszubilden ist.

Durch diese Anordnung ist eine optimale Wärmeableitung des Halbleiterchips 1 sowie ein ideales Verschaltungskonzept bewirkt.

In einem Herstellungsverfahren befinden sich die Leiter 9, 10 in einem ersten bzw. einem zweiten Leadframe, wobei nach umspritzen der Anordnung der Rahmen, der die Leiter während der Herstellung mechanisch verbindet, entfernt wird. Diese Leadframes entsprechen der jeweiligen Ebene 3 oder 4.

In Figur 2 ist eine erfindungsgemäße Weiterbildung der in Figur 1 dargestellten Chipanordnung aufgezeigt. Im Folgenden wird lediglich auf die Unterschiede zwischen Figur 1 und Figur 2 eingegangen. In der Kavität 6 ist zusätzlich zumindest ein zweiter Halbleiterchip 1 eingebracht. Dessen erste Anschlussstelle 7 ist, idealerweise mittels Bondverbindung, mit einem dritten Anschlusskontakt 16 der ersten Ebene 3 verbunden. Die zweite Anschlussstelle 8 des zweiten Halbleiterchips 1 ist ebenfalls elektrisch leitend mit dem zweiten Leiter 10 der zweiten Ebene 4 verbunden.

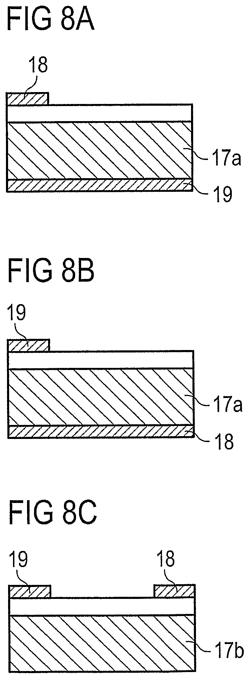

Die zumindest zwei Halbleiterchips 1 können nun beispielsweise unterschiedlich aufgebaute Halbleiterchips 1 sein. Zur Verdeutlichung sei hier auf Figur 8 verwiesen. In einem ersten Fall ist eine Reihenschaltung der Halbleiterchips 1 durch die zweite Ebene 4, die idealerweise elektrisch leitfähig ausgestaltet ist, erreicht. Werden hingegen zumindest zwei gleich aufgebaute Halbleiterchips in die Chipanordnung eingebracht, ist die zweite Ebene 4 der gemeinsame Bezugspunkt. Es kann entweder die Anode oder die Kathode des Halbleiterchips 1 auf den gemeinsamen Bezugspunkt geschalten sein. Ein Betreiben der einzelnen Halbleiterchips 1 ist nun über eine individuelle Spannungsansteuerung über die erste Ebene 3 erreicht.

Durch diese Chipanordnung, speziell durch das Einfügen der separaten Verschaltungsebene 3, ist ein flexibleres Verschalten von unterschiedlich aufgebauten Halbleiterchips 1 realisierbar, ohne aufwendige Isolationsschichten oder Schaltungskonzepte anwenden zu müssen.

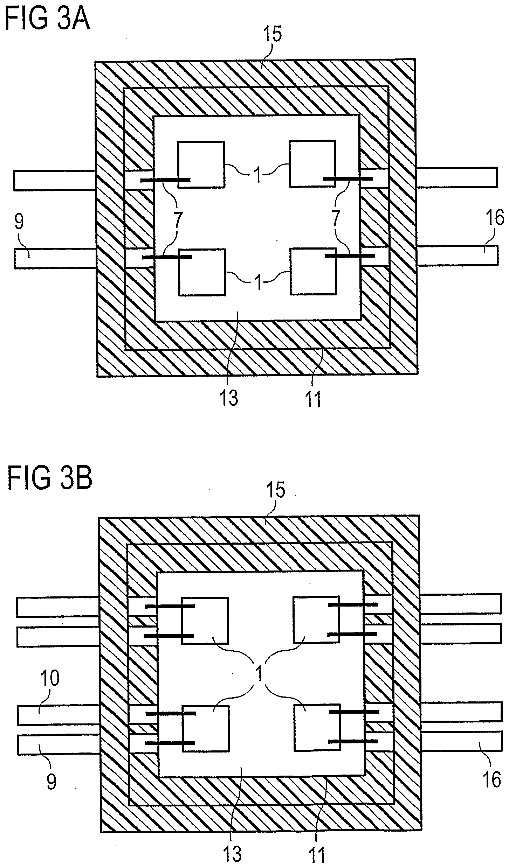

Figuren 3A und 3B zeigen jeweils eine Draufsicht einer Chipanordnung aus Figur 2. In Figur 3A sind vier Halbleiterchips 1 in einer Chipanordnung eingebracht. Die zweiten Anschlussstellen 8 des Halbleiterchips 1 sind alle mittels der zweiten Ebene 4, die elektrisch leitfähig ausgestaltet ist, verbunden. Zusätzlich zum ersten Leiter 9 und dritten Leiter 16 sind für den dritten und vierten Halbleiterchip 1 weitere elektrische Leiter in der ersten Ebene vorgesehen. Zusätzlich ist gezeigt, dass die Abdeckung 11 in das Kunststoffmaterial 15 eingepasst ist.

In einem zweiten nicht dargestellten Fall sind die jeweiligen Halbleiterchips 1 unterschiedlich aufgebaut. Auch hier sei wieder zur Verdeutlichung auf Figur 8 verwiesen. Durch die zweite Ebene 4 sind die Chips 1 untereinander in Reihe verschaltet. Dadurch ist es nur noch nötig, einen ersten Leiter 9 und einen dritten Leiter 16 mittels der ersten Ebene 3 elektrisch leitend nach außen zu führen und über eine anzulegende Spannung zu steuern. Die anzulegende Spannung muss hierbei höher als die Schwellspannung aller in Reihe geschalteter Halbleiterchips 1 sein, um ein Leuchten der Halbleiterchips 1 zu gewährleisten.

Im Unterschied zu Figur 3A ist in Figur 3B jede Anschlussstelle 7 und 8 des jeweiligen Halbleiterchips 1 mit einem elektrisch isolierten Leiter in der ersten Ebene 3 nach außen geführt. Die zweite Ebene 4 ist somit nur als Wärmeableitebene vorgesehen. Sie muss in diesem Fall nicht zwingend elektrisch leitfähig ausgestaltet sein. Vorzugsweise ist die zweite Ebene 4 elektrisch isolierend ausgebildet. Da beide Anschlussstellen 7, 8 auf einer Oberseite der Halbleiterchips angeordnet sind, ist ein isolierendes Substrat innerhalb der Halbleiterchips 1 vorsehbar. Somit wird jeder Halbleiterchip 1 separat angesteuert.

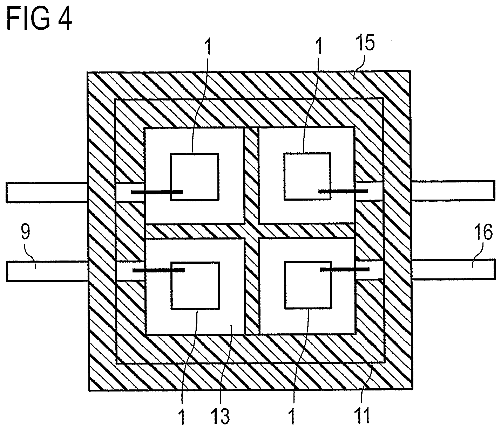

In Figur 4 ist eine Weiterbildung der in Figur 3A dargestellten Chipanordnung aufgezeigt. Im Unterschied zu Figur 3A ist in Figur 4 die zweite Ebene räumlich aufgeteilt.

Durch die Aufteilung der zweiten Ebene 4 wird eine optimale Wärmeableitung erhalten. Die Aufteilung der zweiten Ebene 4 muss nicht zwingend symmetrisch sein, sie ist vielmehr den Wärmeableitanforderungen der jeweiligen unterschiedlich aufgebauten Halbleiterchips 1 anzupassen. Die Ansteuerung und das Einbringen der einzelnen Halbleiterchips 1 gleicht dabei dem in Figur 3A beschriebenen Szenario. Durch Montage der Chipanordnung auf einem elektrisch leitfähigen Kühlkörper oder durch SMT-Montage ist die elektrische Leitfähigkeit der gesamten Schicht 4 gegeben. Nicht dargestellt ist eine Aufteilung der Wärmeableitebene für das in Figur 3B dargestellte Ausführungsbeispiel. Da hierin jeder Chip individuell ansteuerbar ist, können die Wärmeableitebene und auch der Kühlkörper elektrisch isolierend ausgestaltet sein.

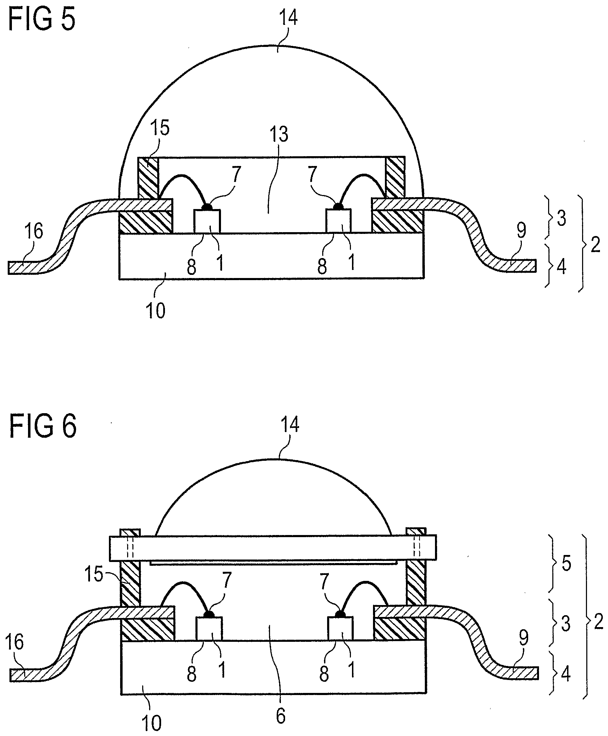

In Figur 5 ist eine LED mit einer der vorher beschriebenen Chipanordnung aufgezeigt. Im Unterschied zur Figur 2 ist hier eine Linse als optisches Element 14 vorgesehen anstelle der Abdeckung 11. Mittels dieses optischen Elements 14 ist es vereinfacht möglich, die Lichtstrahlen zu bündeln, zu streuen oder abzulenken.

In Figur 6 ist eine Weiterbildung der in Figur 5 dargestellten LED aufgezeigt. Die Anschlussanordnung 2 weist hier drei Ebenen auf, wobei die dritte Ebene 5 als Halteebene für das optische Element 14 dient. Die Linse ist vorzugsweise aus Silikon oder einem anderen thermoplastischen Kunststoff. Mittels Spritzgussverfahren werden vorzugsweise Epoxyde zwischen den einzelnen Schichten 3, 4 und 5 der Anschlussanordnung 2 eingebracht und erzeugen dadurch die elektrische Isolation der einzelnen Ebenen.

Die dritte Ebene 5 ist in einem Herstellungsverfahren ebenfalls mittels Leadframe herstellbar. Prinzipiell sind somit zur Herstellung einer solchen Chipanordnung drei Flächen auszustanzen. Diese Flächen weisen die für die jeweilige Ebene nötigen Eigenschaften hinsichtlich elektrischer und thermischer Leitfähigkeit auf. Bezüglich der Eigenschaften sind pro Leadframe andere Materialien anwendbar. Idealerweise werden die Leadframes nach ihrer Fertigung und Anordnung mittels Kunststoff umspritzt. Dazu ist bevorzugt ein Spritzgussverfahren anzuwenden. Dadurch wird zum einen eine elektrische Isolation der einzelnen Leadframes erreicht, zum anderen ist durch diese Mehrschicht-Leadframe-Fertigung vereinfacht ein Verschalten unterschiedlich aufgebauter Halbleiterchips 1 ermöglicht. Nach erfolgtem Umspritzen werden die Rahmen um die einzelnen Leiter 9, 10, 16 bzw. der Wärmeableitebene 4 und der Halteebene 5 entfernt.

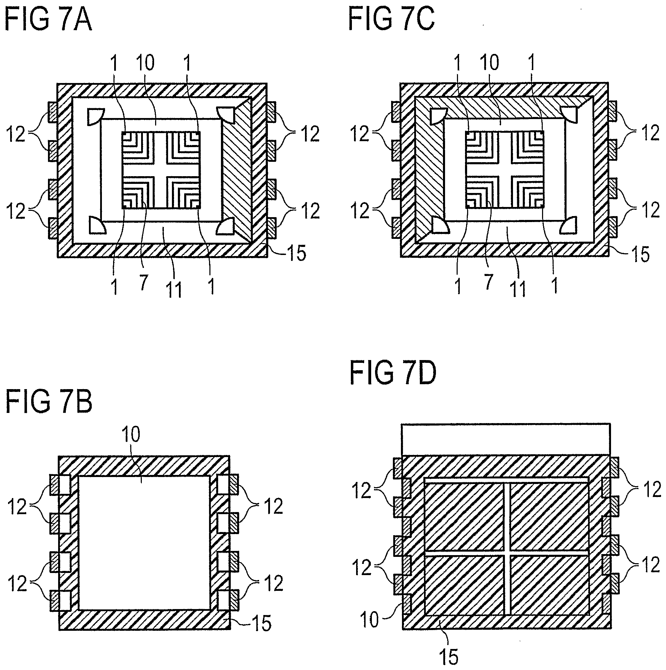

In den Figuren 7A bis 7D sind verschiedene dreidimensionale LEDs mit Chipanordnungen aufgezeigt. Die elektrischen Anschlüsse 12 dienen hierbei als SMT-Kontaktierungen. In einem anderen Fall können die elektrischen Anschlüsse 12 als Steckerkontakten, Lötpins und/oder Schneidklemmverbindungen ausgebildet sein. Diese elektrischen Anschlüsse 12 sind vorzugsweise IEC- oder DIN-genormt. In den Figuren 7A und 7C weisen die Halbleiterchips 1 zusätzlich Stromleitschienen auf, welche einer schlechten Stromleitfähigkeit des jeweiligen dotierten Materials entgegenwirken. Diese Stromleitschienen können sternförmig, rund, quadratisch oder den jeweiligen Gegebenheiten angepasst ausgestaltet sein.

In Figur 8 sind die eingangs prinzipiell unterschiedlichen aufgebauten Halbleiterchips 1 dargestellt. In Figur 8A ist ein nicht-isolierendes Substrat 17a auf einer Unterseite mit einer n-Anschlussstelle 19 vorgesehen. Auf der der Unterseite gegenüberliegenden Seite ist eine p-Anschlussstelle 18 vorgesehen. Im Gegensatz dazu sind in Figur 8B beide Anschlussstellen 18, 19 vertauscht. In Figur 8C ist ein isolierendes Substrat 17b mit auf einer Oberseite vorgesehenen Anschlussstellen 18, 19 ausgebildet.

Allgemein dient ein Spritzgussverfahren dazu, Epoxyde zwischen die einzelnen Schichten der Anschlussanordnung einzubringen, wodurch die elektrische Isolation der einzelnen Schichten erreicht wird. Durch die Anschlussanordnung wird die Verschaltungsebene 3 von der Wärmeableitebene 4 getrennt, wodurch die Verschaltungs- und Anschlussebene mit mehr Funktionalität ausgestattet sind.

Zusätzlich können auf dem Halbleiterchip 1 noch Stromleitbahnen angeordnet sein, um der schlechten Leitfähigkeit des dotierten Grundmaterials entgegenzuwirken.

## Patentansprüche

1. Chipanordnung für ein optoelektronisches Bauelement, mit zumindest einem, eine elektromagnetische Strahlung emittierenden Halbleiterchip (1) und einer Anschlussanordnung (2), wobei:
- die Anschlussanordnung (2) voneinander elektrisch isolierte Ebenen (3,4) aufweist,
- in zumindest zwei Ebenen (3,4) zumindest zwei elektrisch isolierte Leiter (9, 10) angeordnet sind,
- zumindest eine Ebene (3,4) eine Kavität (6) aufweist, der Halbleiterchip (1) innerhalb der Kavität(6) angeordnet ist und zumindest zwei Anschlussstellen (7,8) aufweist,
- jede der Anschlussstellen (7,8) mit jeweils einem der Leiter (9, 10) elektrisch leitend verbunden ist und
- zumindest eine der Ebenen (4) eine Wärmeableitebene ist,
- zumindest ein zweiter Halbleiterchip (1) innerhalb der Kavität (6) vorgesehen ist,
- der zweite Halbleiterchip(1) ebenfalls zumindest zwei Anschlussstellen (7,8) aufweist,
- in zumindest zwei Ebenen (3,4) zumindest zwei weitere elektrisch isolierte Leiter angeordnet sind,
- jede der Anschlussstellen (7,8) des zweiten Halbleiterchips mit jeweils einem der weiteren Leiter elektrisch leitend verbunden ist und
- zumindest eine der Ebenen (3,4) elektrisch isoliert ausgestaltet ist.

2. Eine Chipanordnung nach Anspruch 1, wobei die Wärmeableitebene aufgeteilt und die Teile derart räumlich voneinander getrennt sind, dass für jeden Halbleiterchip (1) einzeln optimal Wärme ableitbar ist.

3. Eine Chipanordnung nach einem der Ansprüche 1 oder 2, wobei die Halbleiterchips (1) innerhalb der Chipanordnung untereinander in Reihe und/oder parallel verschaltbar sind.

4. Eine Chipanordnung nach einem der vorhergehenden Ansprüche, wobei die Chipanordnung ein optisches Element (14) aufweist.

5. Eine Chipanordnung nach einem der vorhergehenden Ansprüche, wobei die Anschlussanordnung eine dritte Ebene (5) aufweist und die dritte Ebene (5) als Halteebene für das optische Element (14) ausgebildet ist.

6. Eine Chipanordnung nach einem der vorhergehenden Ansprüche, wobei die Leiter (9, 10) mit elektrischen Anschlüsse (12) in Form von Steckerkontakten, Lötpins und/oder Schneidklemmverbindungen elektrisch leitend verbunden sind.

7. Eine Chipanordnung nach einem der vorhergehenden Ansprüche, wobei die Halbleiterchips (1) ein elektrisch isolierendes Platinsubstrat (17b) aufweisen.

8. Eine Chipanordnung nach einem der vorhergehenden Ansprüche, wobei die Wärmeableitebene (4) eine Wärmesenke ist und direkt mit einem elektrisch leitfähigen Kühlkörper wärmekoppelbar ist.

9. Verfahren zur Herstellung einer Chipanordnung nach einem der Ansprüche 1 bis 8 mit den Verfahrensschritten:
- Fertigen eines ersten Leadframes und Ausbilden dieses ersten Leadframes als Anschluss-Leadframe,
- Fertigen eines zweiten Leadframes und Ausbilden dieses zweiten Leadframes als ein Wärmeableit-Leadframe,
- Umspritzen der Leadframes mittels Spritzgussverfahren,
- Ausbilden einer Kavität innerhalb zumindest eines Leadframes,
- Einbringen von Halbleiterchips innerhalb der Kavität,
- Elektrisches Verbinden der Halbleiterchips mit den Leadframes und
- Vergießen der Halbleiterchips innerhalb der Kavität.

10. Verfahren nach Anspruch 9, wobei der Wärmeleit-Leadframe räumlich aufgeteilt ist und dadurch für jeden Halbleiterchip optimal Wärme abgeleitet wird.

## Claims

1. Chip arrangement for an optoelectronic component, comprising at least one semiconductor chip (1) which emits electromagnetic radiation, and comprising a connection arrangement (2), wherein:
- the connection arrangement (2) has planes (3, 4) that are electrically insulated from one another,
- at least two electrically insulated conductors (9, 10) are arranged in at least two planes (3, 4),
- at least one plane (3, 4) has a cavity (6),
- the semiconductor chip (1) is arranged within the cavity (6) and has at least two connection locations (7, 8),
- each of the connection locations (7, 8) is electrically conductively connected to a respective one of the conductors (9, 10) and
- at least one of the planes (4) is a heat dissipating plane,
- at least one second semiconductor chip (1) is provided within the cavity (6),
- the second semiconductor chip (1) likewise has at least two connection locations (7, 8),
- at least two further electrically insulated conductors are arranged in at least two planes (3, 4),
- each of the connection locations (7, 8) of the second semiconductor chip is electrically conductively connected to a respective one of the further conductors and
- at least one of the planes (3, 4) is configured in electrically insulated fashion.

2. Chip arrangement according to Claim 1, wherein the heat dissipating plane is divided and the parts are spatially separated from one another in such a way that heat can be optimally dissipated individually for each
semiconductor chip (1).

3. Chip arrangement according to either of Claims 1 and 2, wherein the semiconductor chips (1) can be interconnected in series and/or in parallel within the chip arrangement.

4. Chip arrangement according to any of the preceding claims, wherein the chip arrangement has an optical element (14).

5. Chip arrangement according to any of the preceding claims, wherein the connection arrangement has a third plane (5) and the third plane (5) is embodied as a holding plane for the optical element (14).

6. Chip arrangement according to any of the preceding claims, wherein the conductors (9, 10) are electrically conductively connected to electrical connections (12) in the form of plug contacts, soldering pins and/or insulation displacement connections.

7. Chip arrangement according to any of the preceding claims, wherein the semiconductor chips (1) have an electrically insulating platinum substrate (17b).

8. Chip arrangement according to any of the preceding claims, wherein the heat dissipating plane (4) is a heat sink and can be thermally coupled directly to an electrically conductive cooling body.

9. Method for producing a chip arrangement according to any of Claims 1 to 8 comprising the following method steps:
- producing a first leadframe and embodying said first leadframe as a connection leadframe,
- producing a second leadframe and embodying said second leadframe as a heat dissipating leadframe,
- encapsulating the leadframes by means of injection molding methods,
- forming a cavity within at least one leadframe,
- introducing semiconductor chips within the cavity,
- electrically connecting the semiconductor chips to the leadframes, and
- potting the semiconductor chips within the cavity.

10. Method according to Claim 9, wherein the heat conducting leadframe is spatially divided and heat is thereby optimally dissipated for each semiconductor chip.

## Revendications

1. Arrangement de puce pour un composant optoélectronique, comprenant au moins une puce en semiconducteur (1) émettant un rayonnement électromagnétique et un arrangement de raccordement (2),
- l'arrangement de raccordement (2) possédant des plans (3, 4) électriquement isolés entre eux,
- au moins deux conducteurs (9, 10) électriquement isolés étant disposés dans au moins deux plans (3, 4),
- au moins un plan (3, 4) possédant une cavité (6),
- la puce en semiconducteur (1) étant disposée à l'intérieur de la cavité (6) et possédant au moins deux points de raccordement (7, 8),
- chacun des points de raccordement (7, 8) étant relié de manière électriquement conductrice respectivement à l'un des conducteurs (9, 10), et
- au moins l'un des plans (4) étant un plan de dissipation de chaleur,
- au moins une deuxième puce en semiconducteur (1) se trouvant à l'intérieur de la cavité (6),
- la deuxième puce en semiconducteur (1) possédant elle aussi au moins deux points de raccordement (7, 8),
- au moins deux conducteurs électriquement isolés supplémentaires étant disposés dans au moins deux plans (3, 4),
- chacun des points de raccordement (7, 8) de la deuxième puce en semiconducteur étant relié de manière électriquement conductrice respectivement à l'un des conducteurs supplémentaires, et
- au moins l'un des plans (3, 4) étant réalisé électriquement isolé.

2. Arrangement de puce selon la revendication 1, le plan de dissipation de chaleur étant divisé et les parties étant mutuellement séparées dans l'espace de telle sorte qu'une chaleur peut être dissipée individuellement de manière optimale pour chaque puce en semiconducteur (1).

3. Arrangement de puce selon l'une des revendications 1 ou 2, les puces en semiconducteur (1) pouvant être connectées entre elles en série et/ou en parallèle à l'intérieur de l'arrangement de puce.

4. Arrangement de puce selon l'une des revendications précédentes, l'arrangement de puce possédant un élément optique (14).

5. Arrangement de puce selon l'une des revendications précédentes, l'arrangement de raccordement possédant un troisième plan (5) et le troisième plan (5) étant réalisé sous la forme d'un plan de maintien pour l'élément optique (14).

6. Arrangement de puce selon l'une des revendications précédentes, les conducteurs (9, 10) étant reliés de manière électriquement conductrice à des bornes électriques (12) sous la forme de contacts mâles, de broches à braser et/ou de raccords à borne guillotine.

7. Arrangement de puce selon l'une des revendications précédentes, les puces en semiconducteur (1) possédant un substrat formant platine (17b) électriquement isolant.

8. Arrangement de puce selon l'une des revendications précédentes, le plan de dissipation de chaleur (4) étant un dissipateur de chaleur et pouvant être couplé thermiquement directement avec un radiateur électriquement conducteur.

9. Procédé de fabrication d'un arrangement de puce selon l'une des revendications 1 à 8, comprenant les étapes suivantes :
- fabrication d'une première grille de connexion et façonnage de cette première grille de connexion en tant que grille de connexion de raccordement,
- fabrication d'une deuxième grille de connexion et façonnage de cette deuxième grille de connexion en tant que grille de connexion de dissipation de chaleur,
- surmoulage des grilles de connexion au moyen d'un procédé de moulage par injection,
- formation d'une cavité à l'intérieur d'au moins une grille de connexion,
- introduction de puces en semiconducteur à l'intérieur de la cavité,
- connexion électrique des puces en semiconducteur avec les grilles de connexion et
- encapsulation des puces en semiconducteur à l'intérieur de la cavité.

10. Procédé selon la revendication 9, la grille de connexion de dissipation de chaleur étant divisée dans l'espace et la chaleur est ainsi dissipée de manière optimale pour chaque puce en semiconducteur.
